# EUROPEAN PATENT APPLICATION

(11) **EP 4 686 328 A1**
(43) Date of publication of application: **28.01.2026**
(21) Application number: 24223035.7
(22) Date of filing: 23.12.2024
(51) Int. Cl.: H05K 7/20

(54) **LIQUID-COOLED HIGH-VOLTAGE BOX AND ENERGY STORAGE BATTERY SYSTEM**

(30) Priority: 26.07.2024 CN 202421801121 U; 11.09.2024 WO PCT/CN2024/118234
(71) Applicant: Eve Energy Storage Co., Ltd, Wuhan, Hubei 430000 (CN)
(72) Inventor: HUANG, Mingxiang, Wuhan, 430000 (CN); SUN, Hui, Wuhan, 430000 (CN)
(74) Representative: HGF

(57) **Abstract**

Provide are a liquid-cooled high-voltage box and an energy storage battery system, which relates to the field of battery energy storage systems. The liquid-cooled high-voltage box includes a base plate (1), a cover plate (2), and a frame; the base plate (1), the cover plate (2), and the frame encloses a chamber (5), a cavity (4) is arranged in the base plate (1), and the high-voltage component (18) is arranged on the base plate (1); an inlet (6) through which the liquid coolant is injected and an outlet (7) through which the liquid coolant is discharged are arranged on the base plate (1), and the inlet (6), the cavity (4), and the outlet (7)sequentially communicate with each other.

## Description

### TECHNICAL FIELD

The present application relates to the field of battery energy storage systems, for example, to a liquid-cooled high-voltage box and an energy storage battery system.

### BACKGROUND

A high-voltage box is a device for containing a battery management system, and high-voltage components for controlling a battery high-voltage system are installed in the high-voltage box. These high-voltage components will emit a large amount of heat during use. To avoid damage to the high-voltage components due to excessive temperature, the high-voltage box needs to have good heat dissipation performance, but the high-voltage box itself needs a good sealing property.

The high-voltage box in the related art usually can only dissipate heat naturally and thus has poor heat dissipation performance. If the heat dissipation performance is to be improved, the manner of opening heat dissipation holes or installing heat dissipation devices such as fans on the box of the high-voltage box is generally adopted, thereby making the high-voltage box fail to have a good sealing property.

### SUMMARY

The present application provides a liquid-cooled high-voltage box. The liquid-cooled high-voltage box includes a base plate, a cover plate, and a frame. The base plate is disposed on a first side of the frame, and the cover plate is disposed on a second side of the frame. The base plate, the cover plate, and the frame encloses a chamber configured for accommodating high-voltage components, and at least part of the base plate includes a cavity configured for allowing a liquid coolant to flow. The high-voltage components are disposed on the base plate, and part of the high-voltage components are disposed directly above the cavity configured for allowing the liquid coolant to flow. An inlet and an outlet are disposed on the base plate, the inlet is configured for injecting the liquid coolant, the outlet is configured for discharging the liquid coolant, the inlet communicates with the cavity, and the cavity communicates with the outlet.

The present application further provides an energy storage battery system. The energy storage battery system includes a battery pack, high-voltage components, and the liquid-cooled high-voltage box. The battery pack is arranged on one side of the liquid-cooled high-voltage box, the high-voltage components are arranged in the liquid-cooled high-voltage box, and the battery pack is electrically connected to the high-voltage components.

### BENEFICIAL EFFECTS

The present application has the following beneficial effects.

By opening the cavity in the base plate and injecting the liquid coolant into the cavity, the heat dissipation of the high-voltage components is achieved through the heat exchange between the liquid coolant and the high-voltage components in the liquid-cooled high-voltage box. By continuously injecting the liquid coolant with a lower temperature into the cavity through the inlet and discharging the liquid coolant which absorbs the heat of the high-voltage components and has a higher temperature in the cavity from the outlet, the effect of maintaining the liquid coolant in the cavity at a lower temperature is achieved. With no need to open heat dissipation holes or install heat dissipation devices such as fans on the base plate, the cover plate, and the frame, the sealing property of the chamber enclosed by the base plate, the cover plate or the frame is ensured.

### BRIEF DESCRIPTION OF THE DRAWINGS

FIG. 1 is a schematic view of the overall structure of a liquid-cooled high-voltage box provided by some embodiments of the present application;
FIG. 2 is a schematic view of the structure of the liquid-cooled high-voltage box with the cover plate removed provided by some embodiments of the present application;
FIG. 3 is a schematic view of the inner structure of the liquid-cooled high-voltage box provided by some embodiments of the present application;
FIG. 4 is an enlarged view of part A in FIG. 3;
FIG. 5 is a schematic view of the structure of the base plate of the liquid-cooled high-voltage box provided by some embodiments of the present application;
FIG. 6 is a schematic view of the inner structure of the base plate of the liquid-cooled high-voltage box provided by some embodiments of the present application;
FIG. 7 is a schematic view of the overall structure of an energy storage battery system provided by some embodiments of the present application;
FIG. 8 is a schematic view of the structure of the energy storage battery system with the cover plate removed provided by some embodiments of the present application; and
FIG. 9 is a schematic view of the structure of a battery pack and the liquid-cooled high-voltage box provided by some embodiments of the present application.

In the drawings:
1. base plate; 101. upper plate; 102. lower plate; 2. cover plate; 3. side plate; 4. cavity; 401. strong cooling zone; 402. weak cooling zone; 5. chamber; 6. inlet; 7. outlet; 8. connecting edge; 9. isolation strip; 10. flow channel; 11. spacer bar; 12. boss; 13. outlet pipe; 14. inlet pipe; 15. support protrusion; 16. support plate; 17. sealing strip; 18. high-voltage component; 19. battery pack; 20 liquid-cooled high-voltage box.

### DETAILED DESCRIPTION

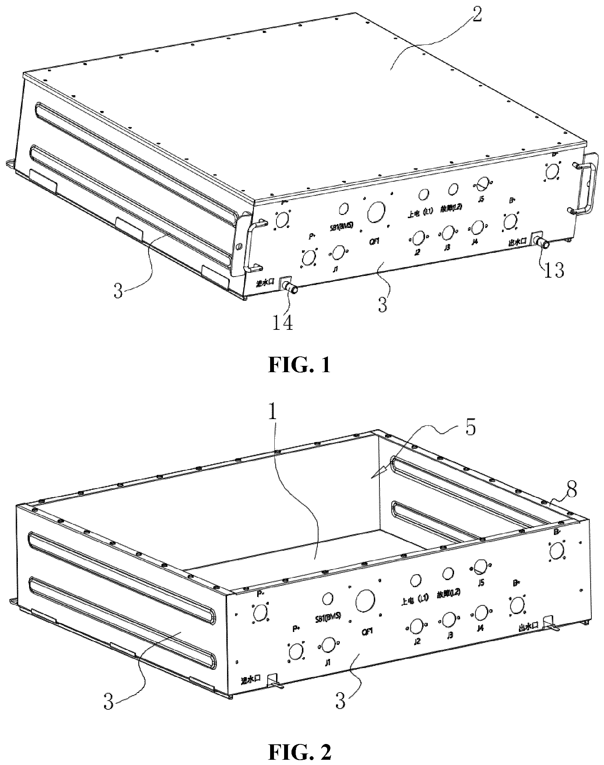

As shown in FIGS. 1 and 2, the present application provides a liquid-cooled high-voltage box. The liquid-cooled high-voltage box includes a base plate 1, a cover plate 2, and a frame. The base plate 1 is arranged on a first side of the frame, and the cover plate 2 is arranged on a second side of the frame. The base plate 1, the cover plate 2, and the frame encloses a chamber 5 for accommodating high-voltage components 18, and at least part of the base plate 1 includes a cavity 4 for allowing a liquid coolant to flow. An inlet 6 through which the liquid coolant is injected and an outlet 7 through which the liquid coolant is discharged are arranged on the base plate 1, and the inlet 6 and the outlet 7 both communicate with the cavity 7.

The frame includes multiple connected side plates 3 surrounding the chamber 5. The base plate 1, the cover plate 2, and the side plates 3 are all rectangular plates. The base plate 1, the cover plate 2, and the side plates 3 form a hollow cuboid. The side plates 3 may be connected to the base plate 1 through the manner of welding or by being integrally formed. In this embodiment, the side plates 3 are integrally formed with the base plate 1. After the side plates 3 are integrally formed with the base plate 1, the side plates 3 may be bent upwardly to a perpendicular degree to the base plate 1. The top portions of the side plates 3 are bent towards the chamber 5 to form connecting edges 8 that fit with the cover plate 2. The cover plate 2 is covered on the top portions of the side plates 3 and abuts against the connecting edges 8. The cover plate 2 and the connecting edges 8 are fixed by bolts so that the cover plate 2 is conveniently opened for maintenance of the high-voltage components 18 in the liquid-cooled high-voltage box. The base plate 1 includes an upper plate 101 and a lower plate 102, and a spacing between the upper plate 101 and the lower plate 102 is the cavity 4. The high-voltage components 18 are all installed on the upper plate 101 so that the high-voltage components 18 can directly exchange heat with the liquid coolant in the cavity 4 through the upper plate 101. The liquid coolant may be a liquid having a large specific heat capacity such as an ethylene glycol coolant solution, a glycerol coolant solution or water, and water is adopted in this embodiment. During use, by continuously injecting the liquid coolant with a lower temperature into the cavity 4 and discharging the liquid coolant which absorbs the heat of the high-voltage components 18 and has a higher temperature in the cavity 4 from the outlet 7, the effect of maintaining the liquid coolant in the cavity 4 at a lower temperature is achieved.

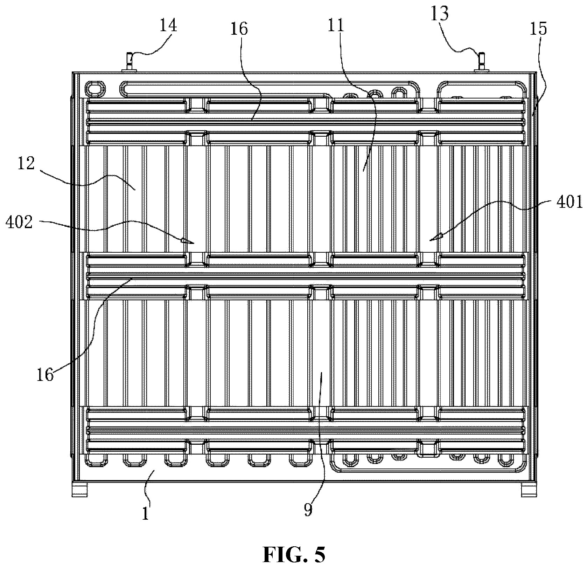

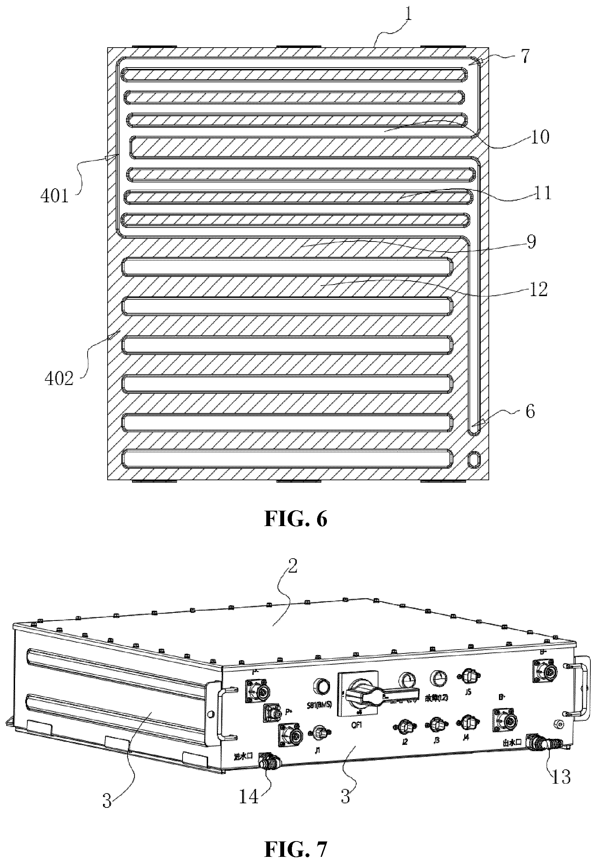

With reference to FIGS. 5 and 6, in this embodiment, the cavity 4 includes a strong cooling zone 401 and a weak cooling zone 402. The liquid coolant flows through the strong cooling zone 401.

Since part of the high-voltage components 18 in the liquid-cooled high-voltage box have a relatively low degree of heat generation during use, such as circuit breakers, these high-voltage components 18 that generate a smaller amount of heat may be placed above the weak cooling zone 402; the rest of the high-voltage components 18 that generate a larger amount of heat, such as fuses and pre-charged resistors, may be placed above the strong cooling zone 401. Through the above setting, the targeted cooling can be performed, and the amount of the liquid coolant used can be reduced as much as possible, thereby achieving the cost-saving effect. With reference to FIG. 2, in this embodiment, each of the strong cooling zone 401 and the weak cooling zone 402 occupies half of the cavity 4, that is, the area ratio of the strong cooling zone 401 and the weak cooling zone 402 is 1:1. To prevent the liquid coolant from flowing into the strong cooling zone 401 from the weak cooling zone 402, an isolation strip 9 is further arranged in the cavity 4. The isolation strip 9 is located between the strong cooling zone 401 and the weak cooling zone 402 and extends in the lengthwise direction of the base plate 1. The isolation strip 9 may be an additional strip-shaped object welded in the cavity 4 or may be formed in the cavity 4 by stamping the lower plate 102 of the base plate 1. In this embodiment, the isolation strip 9 is formed by stamping the lower plate 102. The top surface of the isolation strip 9 is welded to the upper plate 101 to separate the strong cooling zone 401 from the weak cooling zone 402.

In this embodiment, a flow channel 10 for allowing the liquid coolant to flow is arranged in the strong cooling zone 401. The inlet 6 communicates with the outlet 7 through the flow channel 10, and the flow channel 10 is distributed throughout the strong cooling zone 401.

With reference to FIGS. 5 and 6, the flow channel 10 is coiled in the lengthwise direction of the strong cooling zone 401 to achieve the effect of traversing the strong cooling zone 401. By setting the flow channel 10, the liquid coolant in the cavity 4 may orderly flow from the inlet 6 to the outlet 7, thereby ensuring that the liquid coolant with a lower temperature injected from the inlet 6 can completely traverse the strong cooling zone 401 and bring out the heat of the high-voltage components 18 in the strong cooling zone 401 and avoiding the case where the liquid coolant with a lower temperature injected into the cavity 4 from the inlet 6 flows out directly from the outlet 7 while the liquid coolant with a higher temperature in the cavity 4 does not flow out.

In this embodiment, multiple spacer bars 11 are arranged in the cavity 4. Two opposite side surfaces of each of the multiple spacer bars 11 are connected to the bottom surface of the cavity 4 and the top surface of the cavity 4, respectively, and a spacing exists between two adjacent spacer bars 11 to form the flow channel 10.

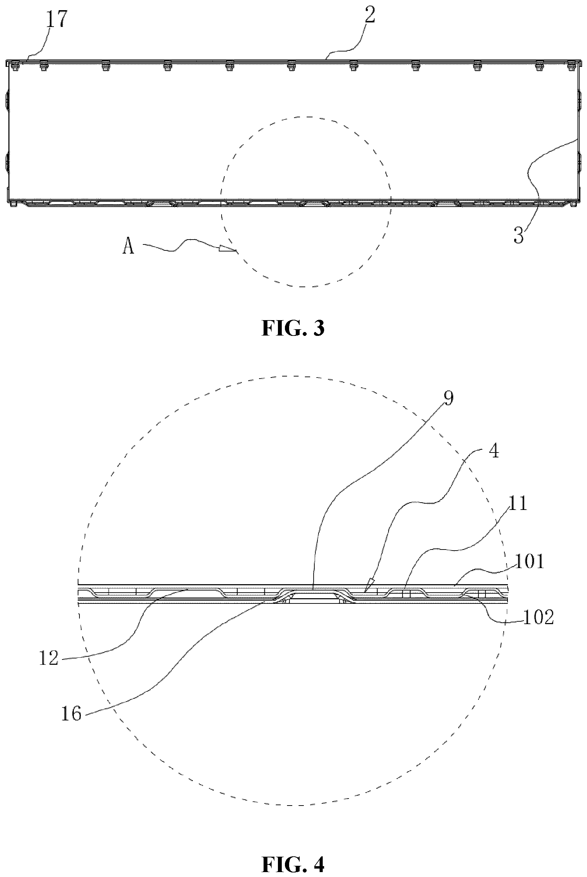

With reference to FIGS. 3 to 6, the multiple spacer bars 11 are arranged in the cavity 4 in the lengthwise direction of the base plate 1. The spacer bar 11 is parallel to the lengthwise direction of the base plate 1. Two ends of the spacer bar 11 are not in contact with the inner wall of the cavity 4 to enable two adjacent flow channels 10 to be in a communicated state. The spacer bar 11 may be a strip-shaped object welded to the bottom surface of the cavity 4 or may be formed by stamping the lower plate 102 of the base plate 1. In this embodiment, the spacer bar 11 is formed by stamping the lower plate 102 of the base plate 1. The top surface of the spacer bar 11 is welded to the upper plate 101 to ensure that the liquid coolant can only flow into the next flow channel 10 from the two ends of the spacer bar 11, thereby preventing the liquid coolant from crossing over the spacer bar 11 and flowing between two adjacent flow channels 10.

In another embodiment, the flow channel 10 may also be a pipe made of a material with high thermal conductivity, such as a copper pipe and a stainless steel pipe, and then the flow channel 10 is tightly attached to the upper plate 101 to reduce the distance between the flow channel 10 and the high-voltage components 18, thereby improving the thermal conductivity efficiency.

In this embodiment, a boss 12 is arranged in the weak cooling zone 402, and two opposite side surfaces of the boss 12 are connected to the bottom surface of the cavity 4 and the top surface of the cavity 4, respectively.

With reference to FIGS. 3 to 6, the boss 12 may be a square column-shaped object welded to the bottom surface of the cavity 4 or may be formed by stamping the lower plate 102 of the base plate 1. In this embodiment, the boss 12 is formed by stamping the lower plate 102 of the base plate 1. The extension direction of the boss 12 is parallel to the extension direction of the spacer bar 11. The boss 12 is arranged on the bottom surface of the cavity 4 in the lengthwise direction of the base plate 1. The top surface of the boss 12 abuts against the top surface of the cavity 4 to support the upper plate 101 of the base plate 1 above the weak cooling zone 402, thereby preventing the upper plate 101 above the weak cooling zone 402 from being depressed due to excessive pressure. The upper plate 101 above the strong cooling zone 401 is supported by the spacer bar 11.

In this embodiment, an outlet pipe 13 and an inlet pipe 14 are arranged on the side plate 3. The outlet pipe 13 communicates with the outlet 7, and the inlet pipe 14 communicates with the inlet 6. Optionally, the outlet pipe 13 and the inlet pipe 14 are arranged on the same side plate 3, and the outlet pipe 13 and the inlet pipe 14 are located at two ends of the side plate 3 in the extension direction, respectively.

The outlet pipe 13 and the inlet pipe 14 extend through the side plate 3 and extend through the upper plate 101 of the base plate 1 to communicate with the strong cooling zone 401 of the cavity 4. Multiple interfaces for power supply lines to pass through or for mounting operating knobs are arranged on the side plate 3 where the inlet pipe 13 and the outlet pipe 14 are arranged. To avoid affecting the wiring connection operations of the user or affecting the use of the operating knobs, the inlet pipe 13 and the outlet pipe 14 may be arranged at the two ends of the side plate 3 in the lengthwise direction. For example, the inlet pipe 14 is arranged at the end near the weak cooling zone 402, and the outlet pipe 13 is arranged at the end near the strong cooling zone 401. Therefore, the temperature of the liquid coolant filled in the flow channel 10 close to the weak cooling zone 402 may be lower. In one aspect, such a setting can assist in lowering the temperature of the weak cooling zone 402, and in another aspect, since the temperature of the middle part of the entire liquid-cooled high-voltage box is higher than the temperature of the edge positions, such a setting can also improve the heat dissipation effect of the middle part of the liquid-cooled high-voltage box.

In this embodiment, multiple support protrusions 15 and multiple support plates 16 for increasing the strength of the base plate 1 are arranged on the side surface, facing away from the cover plate 2, of the base plate 1.

The multiple support plates 16 are arranged in a direction perpendicular to the spacer bar 11. The support plate 16 is attached to the bottom surface of the base plate 1 and is fixed to the base plate 1 by welding. The number of the support plates 16 may be arbitrary. In this embodiment, the number of the support plates 16 is three. The three support plates 16 are arranged in a direction perpendicular to the extension direction of the spacer bar 11, and the distance between two adjacent support plates 16 is equal. The support plate 16 can enhance the structural strength of the base plate 1 to prevent the base plate 1 from being deformed. The support protrusion 15 may be in any form as long as the entire liquid-cooled high-voltage box can be supported to form a spacing between the base plate 1 and the plane on which the liquid-cooled high-voltage box is placed. For example, the support protrusion 15 may be column-shaped or strip-shaped. In this embodiment, the support protrusion 15 is in the shape of a strip having a rectangular cross section, and the multiple support protrusions 15 are arranged on two sides of the base plate 1 in the extension direction of the support plate 16, that is, the extension direction of the support protrusion 15 is perpendicular to the extension direction of the support plate 16. When the liquid-cooled high-voltage box is supported by the support projections 15, the probability that the base plate 1 is scratched can be reduced, thereby protecting the base plate 1.

In this embodiment, a sealing strip 17 is filled between the cover plate 2 and the side plate 3. The sealing strip 17 is arranged on the connecting edge 8 of the side plate 3 by pasting. When the cover plate 2 is covered on the connecting edge 8, the sealing strip 17 fills the gap between the cover plate 2 and the connecting edge 8 to achieve the sealing effect. By setting the sealing strip 17, the waterproofing level of the entire liquid-cooled high-voltage box can be improved.

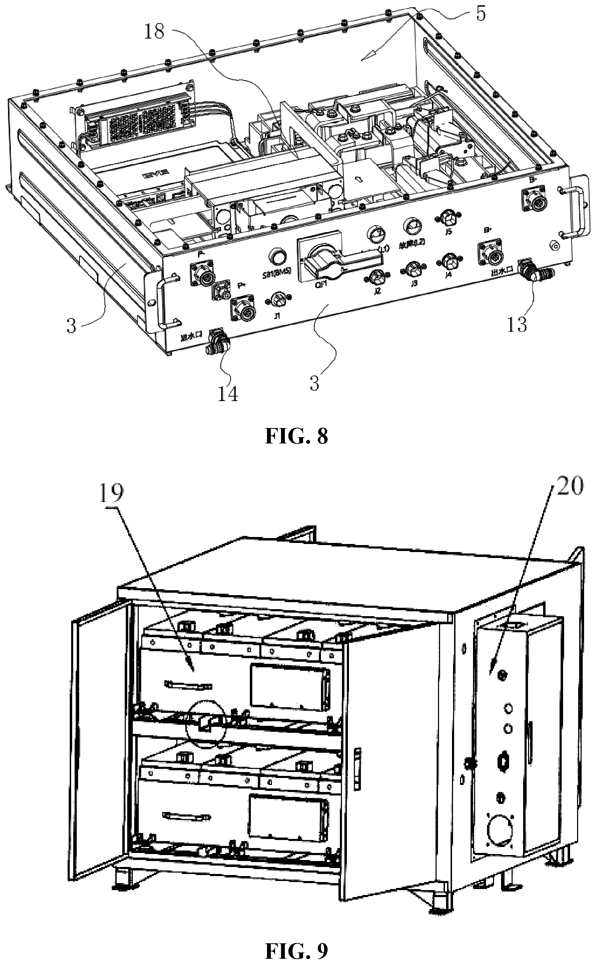

With reference to FIGS. 7, 8, and 9, the present application further provides an energy storage battery system. The energy storage battery system includes a battery pack 19, high-voltage components 18, and a liquid-cooled high-voltage box 20. The battery pack 19 is arranged on one side of the liquid-cooled high-voltage box 20, the high-voltage components 18 are arranged in the liquid-cooled high-voltage box 20, and the battery pack 19 is electrically connected to the high-voltage components 18. By adopting the liquid-cooled high-voltage box provided by the embodiments of the present application to contain the high-voltage components 18, the working temperature of the high-voltage components 18 can be better controlled to avoid the temperature of the high-voltage components 18 being too high, thereby improving the service life of the high-voltage components 18 and reducing the operation failures. Moreover, the liquid-cooled high-voltage box has an excellent sealing property to prevent the high-voltage components 18 from water, thereby improving the working safety of the high-voltage components 18.

## Claims

1. A liquid-cooled high-voltage box, comprising: a base plate (1), a cover plate (2), and a frame, wherein the base plate (1) is disposed on a first side of the frame, and the cover plate (2) is disposed on a second side of the frame; the base plate (1), the cover plate (2), and the frame encloses a chamber (5) configured for accommodating high-voltage components (18), and at least part of the base plate (1) comprises a cavity (4) configured for allowing a liquid coolant to flow; the high-voltage components (18) are disposed on the base plate (1), and part of the high-voltage components (18) are disposed directly above the cavity (5) configured for allowing the liquid coolant to flow; an inlet (6) and an outlet (7) are disposed on the base plate (1), the inlet (6) is configured for injecting the liquid coolant, the outlet (7) is configured for discharging the liquid coolant, the inlet (6) communicates with the cavity (4), and the cavity (4) communicates with the outlet (7).

2. The liquid-cooled high-voltage box according to claim 1, wherein the cavity (4) comprises a strong cooling zone (401) for cooling a high-voltage component (18) which generates a large amount of heat, and a weak cooling zone (402) for cooling a high-voltage component (18) which generates a small amount of heat, and the strong cooling zone (401) is configured to allow the liquid coolant to flow through the strong cooling zone (401).

3. The liquid-cooled high-voltage box according to claim 2, wherein a flow channel (10) configured for allowing the liquid coolant to flow is disposed in the strong cooling zone (401), the inlet (6) communicates with the outlet (7) through the flow channel (10), and the flow channel (10) is distributed throughout the strong cooling zone (401).

4. The liquid-cooled high-voltage box according to claim 3, wherein a plurality of spacer bars (11) are disposed in the cavity (4), two opposite side surfaces of each of the plurality of spacer bars (11) are connected to a bottom surface of the cavity (4) and a top surface of the cavity (4), respectively, and a spacing exists between two adjacent ones of the plurality of spacer bars (11) to form the flow channel (10).

5. The liquid-cooled high-voltage box according to claim 3, wherein a boss (12) is disposed in the weak cooling zone (402), and two opposite side surfaces of the boss (12) are connected to a bottom surface of the cavity (4) and a top surface of the cavity (4), respectively.

6. The liquid-cooled high-voltage box according to claim 1, wherein an outlet pipe (13) and an inlet pipe (14) are disposed on the frame, the outlet pipe (13) communicates with the outlet (7), and the inlet pipe (14) communicates with the inlet (6).

7. The liquid-cooled high-voltage box according to claim 6, wherein the frame comprises a plurality of connected side plates (3) surrounding the chamber (5), the outlet pipe (13) and the inlet pipe (14) are disposed on a same one of the plurality of connected side plates (3), and the outlet pipe (13) and the inlet pipe (14) are located at two ends of the same one of the plurality of connected side plates (3) in an extension direction, respectively.

8. The liquid-cooled high-voltage box according to any one of claims 1 to 7, wherein the base plate (1) is arranged in at least one of the following manners:
a plurality of support protrusions (15) are arranged on a side surface, facing away from the cover plate (2), of the base plate (1), and a spacing between the base plate (1) and a plane on which the liquid-cooled high-voltage box is placed is created by arranging the plurality of support protrusions (15); or
a plurality of support plates (16) for increasing a strength of the base plate (1) are arranged on the side surface, facing away from the cover plate (2), of the base plate (1).

9. The liquid-cooled high-voltage box according to any one of claims 1 to 7, wherein a sealing strip (17) is filled between the cover plate (2) and the frame.

10. An energy storage battery system, comprising: a battery pack (19), high-voltage components (18), and the liquid-cooled high-voltage box (20) according to any one of claims 1 to 9, wherein the battery pack (19) is disposed on one side of the liquid-cooled high-voltage box (20), the high-voltage components (18) are disposed in the liquid-cooled high-voltage box (20), and the battery pack (19) is electrically connected to the high-voltage components (18).
